# Europäisches Patentamt

# European Patent Office

# Office européen des brevets

(11) Veröffentlichungsnummer: **0 151 803**
**B1**

(12) **EUROPÄISCHE PATENTSCHRIFT**

(51) Int. Cl.⁴: **H 04 B 3/40,** H 03 F 1/56, H 03 F 3/19

(45) Veröffentlichungstag der Patentschrift:
09.03.88

(21) Anmeldenummer: 84116323.1

(22) Anmeldetag: 27.12.84

(54) Schaltungsanordnung zur Anpassung eines Verstärkers mit einer Induktivität im Emitterkreis an einem Filter mit einer Eingangsinduktivität.

(30) Priorität: 31.01.84 HU 40184

(43) Veröffentlichungstag der Anmeldung:
21.08.85 Patentblatt 85/34

(45) Bekanntmachung des Hinweises auf die Patenterteilung:
09.03.88 Patentblatt 88/10

(84) Benannte Vertragsstaaten:
AT DE FR GB NL SE

(56) Entgegenhaltungen:
DE - A - 1 957 617
DE - A - 3 000 054
HU - B - 163 449

Q.S.T. AMATEUR RADIO, Band 58, Nr. 12, Dezember 1974, Seiten 48-52, Newington, US; U.L. ROHDE: "Some ideas on antenna couplers"

(73) Patentinhaber: TELEFONGYAR, Hungária körut 126-132, H-1143 Budapest (HU)

(72) Erfinder: Cebe, László, Dipl.-Ing., Kelen József Utca 17, H-1142 Budapest (HU)
Erfinder: Forgó, László, Dr. Dipl.-Ing., Rikushegyi lépcsö 6, H-1022 Budapest (HU)
Erfinder: Tarlacz, László, Dr. Dipl.-Ing., Istenhegyi ut 72, H-1125 Budapest (HU)

(74) Vertreter: Patentanwälte Viering & Jentschura, Steinsdorfstrasse 6, D-8000 München 22 (DE)

ACTORUM AG

## Beschreibung

Die Erfindung betrifft eine Schaltungsanordnung zur Anpassung eines Verstärkers mit einer zwecks Pegelregelung veränderlichen Induktivität im Emitterkreis an ein Filter mit einer Eingangsinduktivität, insbesondere für übertragungstechnische Einrichtungen.

Es ist bekannt, dass in der Übertragungstechnik in vielen Fällen eine Pegelregelung erforderlich ist. Die Pegelregelung wurde früher mittels mechanischer Elemente, z.B. Potentiometer, oder mittels Thermistorschaltungen mit Schrittmotor gelöst (HU-PS 160227).

Da die erwähnten mechanischen Elemente insbesondere durch die Anwendung von Gleitkontakten nicht zuverlässig genug waren, werden in den modernen übertragungstechnischen Einrichtungen Pegelregelungsschaltungen ohne mechanische Kontakte verwendet; in dieser Richtung sind mehrere ungarische Patente erteilt worden.

Eine dieser Lösungen ist aus der HU-PS 163 449 bekannt, die sich in der Praxis gut bewährt hat und auch zur Zeit weitverbreitet verwendet wird. Gemäss dieser Lösung wird der Wert der Induktivität einer im Emitterkreis einer Verstärkerstufe angeordneten Spule verändert und dadurch auch die kontaktlose Pegelregelung erreicht.

In der Übertragungstechnik folgt der Pegelregler-Verstärkerstufe – wie bekannt – fast in allen Fällen ein Filter.

Die Schwierigkeit der Anpassung des Verstärkers und des Filters ist auch bei der Ausführungsform gemäss der oben erwähnten HU-PS 163 449 dadurch bedingt, dass einerseits durch die Induktivität im Emitterkreis die Verstärkung des Verstärkers nicht frequenzunabhängig ist und andererseits zur entsprechenden Abschliessung des Filters eine komplizierte Passstufe erforderlich ist.

Es ist nämlich bekannt, dass die elektrischen Filter für endliche Ohm'sche Abschliessung dimensioniert und hergestellt werden. Diese Abschliessung kann im Grenzfall den Wert von 0 oder von $\alpha$ haben, was jedoch sowohl im Hinblick auf den Stand der Technik als auch im Hinblick auf die erfindungsgemässe Lösung bedeutungslos ist. Hier soll bemerkt werden, dass reaktiv abschliessende Vierpole zwar theoretisch bekannt sind, jedoch infolge der Kompliziertheit ihrer Konstruktion und der Unterschiede zwischen den errechneten und realisierten Parametern der Filter, d.h. wegen der Schwierigkeiten der Kontrollierbarkeit, praktisch nirgendwo verwendet werden.

In der Schaltungsanordnung gemäss der HU-PS 163 449 wird die Impedanzanpassung zwischen dem Verstärker-Pegelregler und dem Filter von einem an den Ausgang des Verstärkers angeschlossenen Transformator mit grossem Übersetzungsverhältnis und einer folgenden Verstärkerstufe durchgeführt, die an den induktiven Eingang des Filters angeschlossen ist. Die frequenzunabhängige Verstärkung des Verstärkers ist durch den Impedanzquotienten der Impedanzen der Primärwicklung des Transformators und der Induktivität des Emitterkreises des Verstärkers bestimmt, d.h.

$$A = \frac{U_2}{U_1} = \frac{L_k}{L_e}$$

wobei

A = Verstärkungskoeffizient
$U_2$ = Ausgangsspannung des Verstärkers
$U_1$ = Eingangsspannung des Verstärkers
$L_k$ = induktive Impedanz der Primärwicklung des Transformators
$L_e$ = Impedanz der Emitterkreisinduktivität des Verstärkers

Das grosse Übersetzungsverhätlnis des erwähnten Anpasstransformators ist dadurch begründet, dass die Impedanz der dem Transformator folgenden Stufen umtransformiert die reine induktive Impedanz der Verstärkersufe nicht stören, d.h. nicht belasten soll.

Zur Kompensation der bedeutenden Spannungsverringerung, die infolge der Notwendigkeit der hohen Abtransformierung entsteht, wird eine dem Transformator folgende aktive Verstärkerstufe verwendet, die gleichzeitig den Ohm'schen Abschluss des Filters sicherstellt.

Aus obigem ist ersichtlich, dass durch die zwangsläufige Anwendung von bekannten Passstufen die Schaltung kompliziert wird, ihr Herstellungsaufwand gesteigert wird und die Möglichkeit des eventuellen Ausfalls von Schaltungselementen proportional zu der Anzahl der verwendeten Elemente steigt.

Das Ziel der Erfindung ist die Ausbildung einer Schaltungsanordnung, die die Anpassung von Verstärkern mit einer Induktivität im Emitterkreis an Filter mit einer in Reihe geschalteten Eingangsinduktivität mit bedeutend weniger Schaltungselementen, geringerem Leistungsbedarf, geringeren Abmessungen und mit grösserer Zuverläsigkeit auf die Weise ermöglicht, dass ohne Verwendung von Passschaltungen mit Verstärker und zweistufigem Transformator der Verstärker und der Filter als ein einziger Vierpol ausgebildet sind.

Das Wesen der Erfindung besteht darin, dass die Schaltungsanordnung als ein einziger Vierpol dadurch ausgebildet ist, dass der Kollektor des Transistors des Verstärkers über einen den Eingang des Filters abschliessenden Widerstand an den Heisspunkt des ohne Eingangsinduktivität verbleibenden Teils des Filters angeschlossen ist und zwischen den gemeinsamen Punkt des Kollektors des Verstärkers und des den Eingang des Filters abschliessenden Widerstandes und den Massepunkt die Eingangsinduktivität geschaltet ist. Die Eingangsinduktivität des Filters ist vorzugsweise als Transformator mit zwei Wicklungen oder als Autotransformator ausgebildet.

Die Charakteristik des erfindungsgemäss als Vierpol ausgebildeten Verstärkers und Filters gleicht gemäss durchgeführten Messungen der mit der herkömmlichen Schaltungsanordnung gemessenen Übertragungscharakteristik.

Ein wesentlicher Vorteil der erfindungsgemässen Schaltungsanordnung besteht darin, dass diese einfach aufgebaut und unaufwendig ist, was sich aus der geringen Anzahl der Schaltungselemente ergibt. Gemäss obigem können ein Transformator mit grossem Übersetzungsverhältnis und eine aktive Verstärkerstufe eingespart werden.

Ein weiterer Vorteil besteht im geringeren Leistungsverbrauch, in der Verringerung der geometrischen Abmessungen und in der höheren Betriebssicherheit und daher Zuverlässigkeit der Einrichtung infolge der Vereinfachung der Schaltung. Die Erhöhung der Zuverlässigkeit ist bei Anwendung der erfindungsgemässen Schaltungsanordnung im Hauptsignalweg, wo die Signale aller Kanäle hindurchlaufen, ein besonders bedeutender Vorteil.

Nachstehend wird die erfindungsgemässe Schaltungsanordnung anhand von bevorzugten Ausführungsformen unter Bezugnahme auf die Zeichnung näher erläutert. Es zeigen:

Fig. 1 ein Blockschema des Verstärkers und des Filters, die aneinander anzupassen sind,

Fig. 2 die Anpassung des in Fig. 1 dargestellten Verstärkers und Filters mittels herkömmlicher Anpassungsschaltungen,

Fig. 3 die erfindungsgemäss als Vierpol ausgebildete Schaltungsanordnung mit Verstärker und Filter und

Fig. 4 eine bevorzugte Ausführungsform der erfindungsgemässen Schaltungsanordnung.

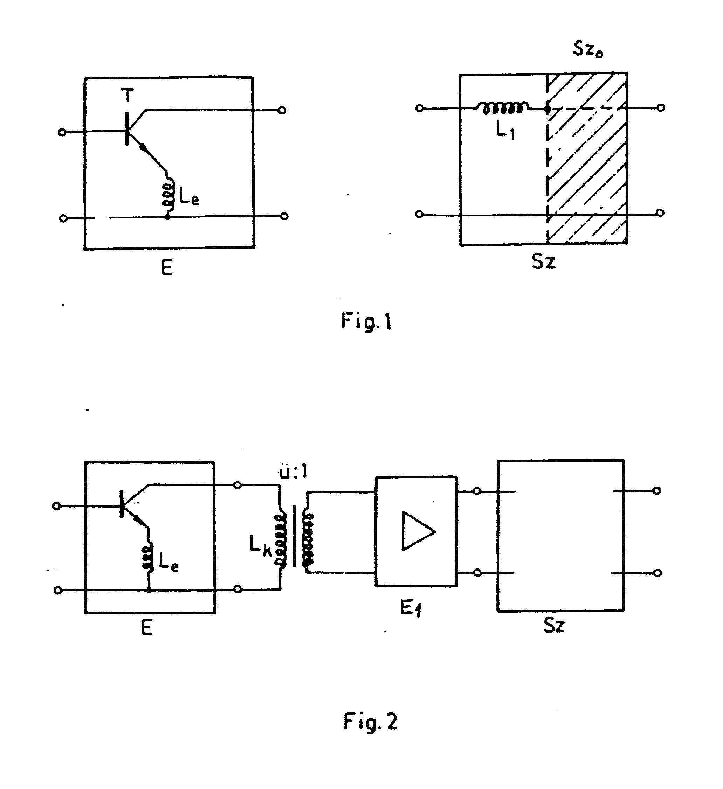

Nach Fig. 1 ist im Emitterkreis eines Transistors T eines Verstärkers E auf herkömmliche Weise eine Induktivität $L_e$ so angeordnet, dass eine in Fig. 2 dargestellte Spule $L_k$, die als Transformator mit grossem Übersetzungsverhältnis verwendet wird, die Anforderung der Frequenzunabhängigkeit des Verstärkungskoeffizienten A erfüllt:

$$A = \frac{U_2}{U_1} = \frac{L_k}{L_e}$$

wobei $U_2$ die Ausgangsspannung des Verstärkers und $U_1$ die Eingangsspannung sind.

Da die Spule $L_k$ einen Transformator mit grossem Übersetzungsverhältnis darstellt, ist zur Kompensation des mittels der Spule erzeugten Spannungsabfalls eine Verstärkerstufe $E_1$ anzuwenden, die gleichzeitig den Ohm'schen Abschluss des Filters Sz sicherstellt. Das Eingangsschaltungselement des Filters Sz ist die Eingangsinduktivität $L_1$, während der in Fig. 1 schraffiert dargestellte Teil des Filters Sz nachfolgend als verbleibender Teil $Sz_0$ bezeichnet ist.

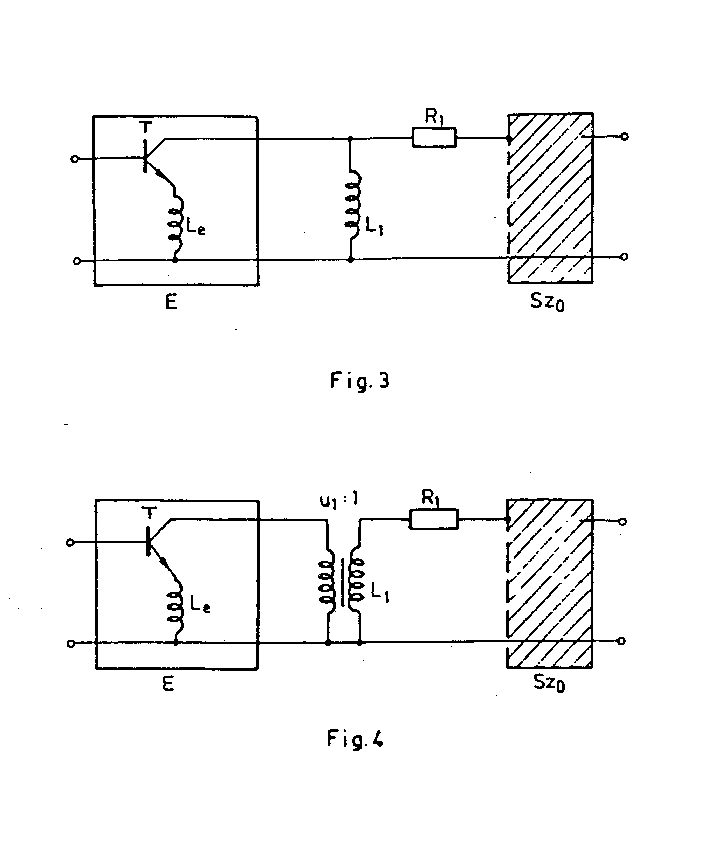

In Fig. 3 ist die allgemeine Lösung des erfindungsgemäss ausgebildeten Verstärker-Filter-Vierpols dargestellt. Der Kollektor des Transistors T des Verstärkers E ist über einen den Eingang des Filters abschliessenden Widerstand $R_1$ an den Heisspunkt des ohne Eingangsinduktivität $L_1$ verbleibenden Teiles $Sz_0$ des Filters angeschlossen. Diese Eingangsinduktivität $L_1$ ist zwischen den gemeinsamen Punkt des Kollektors des Verstärkers E und des den Eingang des Filters abschliessenden Widerstandes $R_1$ und den Massepunkt geschaltet.

Der ohne Eingangsinduktivität $L_1$ verbleibende Teil $Sz_0$ des Filters ist mit einem Ohm'schen Widerstand $R_2$ abgeschlossen (nicht gezeichnet).

In Fig. 4 ist eine Ausführungsform der in Fig. 3 dargestellten Schaltungsanordnung dargestellt, bei der die Induktivität $L_1$ des Filters als ein solcher Transformator ausgebildet ist, dessen Übersetzungsverhältnis wählbar ist, so dass der Ausgangspegel einstellbar ist. Die Übertragungsparameter der in Fig. 3 und Fig. 4 dargestellten Schaltungsanordnung sind zu den Übertragungsparametern der anhand von Fig. 2 erläuterten herkömmlichen, wesentlich komplizierten Schaltungsanordnung identisch.

### Patentansprüche

1. Schaltungsanordnung zur Anpassung eines Verstärkers (E) mit einer zwecks Pegelregelung veränderlichen Induktivität ($L_e$) im Emitterkreis an ein Filter (Sz) mit einer Eingangsinduktivität ($L_1$), insbesondere für Leitungsübertragungseinrichtungen, wobei der Eingang der Schaltungsanordnung von der Basis des Transistors (T) des Verstärkers und den Massepunkt gebildet ist und der Ausgang von dem Heisspunkt des Ausgangs des Filters (Sz) und den Massepunkt gebildet ist, dadurch gekennzeichnet, dass die Schaltungsanordnung als ein einziger Vierpol dadurch ausgebildet ist, dass der Kollektor des Transistors (T) des Verstärkers (E) über einen den Eingang des Filters (Sz) abschliessenden Widerstand ($R_1$) an den Heisspunkt des ohne Eigangsinduktivität ($L_1$) verbleibenden Teils ($Sz_0$) des Filters (Sz) angeschlossen ist und die Eingangsinduktivität ($L_1$) zwischen den gemeinsamen Punkt des Kollektors des Transistors (T) des Verstärkers (E) und des den Eingang des Filters (Sz) abschliessenden Widerstandes ($R_1$) und den Massepunkt geschaltet ist.

2. Schaltungsanordnung nach Anspruch 1, dadurch gekennzeichnet, dass die Eingangsinduktivität ($L_1$) des Filters (Sz) als Transformator oder Autotransformator mit zwei Wicklungen ausgebildet ist.

### Claims

1. Circuit arrangement for adapting an amplifier (E) with an inductance ($L_e$) adjustable for the purpose of level control in the emitter circuit to a filter (Sz) with an input inductance ($L_1$), particularly for transmission transfer devices, the input of the circuit arrangement being formed of the base of the transistor (T) of the amplifier and ground and the output being formed of the active point of the output of the filter (Sz) and ground, characterised in that the circuit arrangement is developed as a simple quatripole network in that the collector of the transistor (T) of the amplifier (E) is connected to the part ($Sz_0$) of the filter (Sz) remaining without input inductance via a resistor ($R_1$) terminating the input of the filter (Sz), and that the input inductance ($L_1$) is provided between ground and the common point of the collector of the transistor (T) of the amplifier (E) and of the resistor (R₁) terminating the input of the filter (Sz).

2. Circuit arrangement according to claim 1, characterised in that the inductance (L₁) of the filter (Sz) is developed as a transformer or an autotransformer with two windings.

**Revendications**

1. Montage pour adapter an amplificateur (E) comportant une inductance (Lₑ) variable à fin de reglage de niveau dans le circuit émetteur à un filtre (Sz) avec une inductance d'entrée (L₁), particulièrement pour dispositifs de transferance de réseaux, l'entrée du montage étant formée de la base du transisteur (T) de l'amplificateur et masse et la sortie du montage étant formée du point actif de la sortie du filtre (Sz) et masse, charactérisé en ce que le montage est developpé comme quatripôle singulier à mesure que le collecteur du transisteur (T) de l'amplificateur (E) est branché au point actif de la partie (Sz₀) du filtre (Sz) restant sans inductance d'entrée via une résistance (R₁) terminant l'entrée du filtre (Sz), et que l'inductance d'entrée (L₁) est branché entre masse et le point collectif du collecteur du transisteur (T) de l'amplificateur (E) et la résistance (R₁) terminant l'entrée du filtre (Sz).

2. Montage suivant la revendication 1, charactérisé en ce que l'inductance d'entrée (L₁) du filtre (Sz) est developpé comme transformateur ou autotransformateur avec deux enroulements.

Fig. 1

Fig. 2

0151803

Fig. 3

Fig. 4

7